# EUROPEAN PATENT APPLICATION

(11) **EP 2 120 522 A1**
(43) Date of publication of application: **18.11.2009**
(21) Application number: 09712697.3
(22) Date of filing: 18.02.2009
(51) Int. Cl.: H05K 3/46, H01G 4/12, H01G 4/30

(54) **METHOD FOR THE PRODUCTION OF LAMINATED CERAMIC ELECTRONIC PARTS**

(30) Priority: 19.02.2008 JP 2008037646
(71) Applicant: Murata Manufacturing Co. Ltd., Kyoto 617-8555 (JP)
(72) Inventor: CHIKAGAWA, Osamu, Nagaokakyo-shi Kyoto 617-8555 (JP); IKEDA, Tetsuya, Nagaokakyo-shi Kyoto 617-8555 (JP)
(74) Representative: Schoppe, Fritz
(86) International application number: PCT/JP2009/052726
(87) International publication number: WO 2009/104619

(57) **Abstract**

In a method for manufacturing a multilayer ceramic substrate in which after firing is performed while restriction layers which are not sintered in the firing are disposed on primary surfaces of an unsintered ceramic laminate, the restriction layers are removed, when a bonding force generated by each restriction layer is increased, the restriction layers cannot be easily removed, and when the restriction layers are designed to be easily removed, the bonding force decreases.

In an unsintered ceramic laminate (12), conductive patterns (5 to 9) containing Ag as a primary component are formed, and in addition, at least one first base layer (1) and at least one second base layer (2) are also laminated to each other. The second base layer (2) is disposed along at least one primary surface of the unsintered ceramic laminate (12), and restriction layers (10, 11) are disposed so as to be in contact with the second base layers (2). The second base layer (2) is formed to have a composition so that Ag is likely to diffuse in firing as compared to that of the first base layer, and as a result, the glass softening point decreases; hence, a restriction force is improved without using means for decreasing the particle diameter of a sintering resistant ceramic powder contained in the restriction layers.

## Description

### Technical Field

The present invention relates to a method for manufacturing a multilayer ceramic electronic device, and in more particular relates to a method for manufacturing a multilayer ceramic electronic device using a so-called non-shrinkage process.

### Background Art

A multilayer ceramic substrate as one example of a multilayer ceramic electronic device has a plurality of laminated ceramic layers, and in general, conductive patterns are formed on surfaces and inside the ceramic layers. As the conductive patterns described above, for example, in-plane conductors extending in a plane direction of the ceramic layers and interlayer connection conductors (represented by via hole conductors) extending to penetrate the ceramic layers in a thickness direction may be mentioned.

In general, the multilayer ceramic substrate as described above mounts surface mount electronic devices, such as a semiconductor device and a chip multilayer capacitor, and electrically connects between these surface-mount electronic devices. In addition, in the case in which passive elements, such as a capacitor and an inductor, are embedded in the multilayer ceramic substrate, the passive elements are formed from the above described in-plane conductors and interlayer connection conductors and are, whenever necessary, connected with the individual surface mount electronic devices.

In order to form a multilayer ceramic substrate having more multifunctions, higher functions, and more superior performance, the conductive patterns described above must be formed to have a high accuracy and a high density.

Incidentally, in order to obtain a multilayer ceramic substrate, an unsintered ceramic laminate formed of laminated ceramic green sheets which are to be formed into ceramic layers must be fired. In this firing step, the ceramic green sheets are shrunk due to the loss of a binder contained therein and/or sintering of a ceramic powder, and in particular in the case of a multilayer ceramic substrate having a large area, the shrinkage is not likely to uniformly occur over the entire substrate. Hence, dimensional errors may be generated in a plane direction of the multilayer ceramic substrate due to non-uniform shrinkage, and/or the entire multilayer ceramic substrate may be warped or undulated in some cases.

As a result, the conductive patterns may be undesirably deformed and/or warped, and in more particular, the positional accuracy of the in-plane conductors and that of the interlayer connection conductors may be degraded, or disconnection may occur in the in-plane conductors and the interlayer connection conductors in some cases. The deformation and the warping generated in the conductive patterns are primary causes of preventing an increase in density of the conductive pattern.

Accordingly, for example, in Japanese Patent No. 2554415 (Patent Document 1), a technique which uses a method, a so-called non-shrinkage process, has been proposed in which when a multilayer ceramic substrate is manufactured, a firing shrinkage thereof in a plane direction is substantially inhibited.

In this non-shrinkage process, base-layer ceramic green sheets are prepared which are primarily composed of a base-layer ceramic powder formed by mixing a ceramic powder such as Al₂O₃ and a glass powder such as a borosilicate glass, and in addition, restriction-layer ceramic green sheets primarily composed, for example, of an Al₂O₃ powder are prepared. Subsequently, after in-plane conductors and interlayer connection conductors are formed on and in the base-layer ceramic green sheets, these ceramic green sheets are laminated to each other to form an unsintered ceramic laminate, and the restriction-layer ceramic green sheets are disposed on the top and the bottom primary surfaces of this unsintered ceramic laminate and are then pressure-bonded thereto, so that a composite laminate composed of the unsintered ceramic laminate and the restriction layers provided thereon is formed.

The composite laminate thus obtained is processed by a heat treatment to remove organic components, such as a binder, contained in the individual ceramic green sheets and is then fired at a temperature at which the unsintered ceramic laminate is sintered, that is, at a temperature at which the base-layer ceramic powder is sintered. In this firing step, since the Al₂O₃ powder contained in the restriction layers are not substantially sintered, the restriction layers are not substantially shrunk, so that a restriction force works on each of the top and the bottom primary surfaces of the unsintered ceramic laminate. As a result, the shrinkage of the unsintered ceramic laminate in a plane direction is substantially suppressed, and the unsintered ceramic laminate is shrunk substantially only in a thickness direction. In addition, after the firing step, when pore layers composed of the Al₂O₃ powder derived from the restriction layers are removed, a sintered ceramic laminate, which is the multilayer ceramic substrate, is obtained.

Accordingly to the non-shrinkage process described above, since the dimensional accuracy of the laminated base-layer ceramic green sheets is maintained in a plane direction, uneven deformation is not likely to occur, and thereby undesired deformation and warping of the conductive patterns are not likely to occur, so that a multilayer ceramic substrate having a highly reliable conductive patterns which are formed with high accuracy can be obtained.

However, as for the properties of the restriction layer of the non-shrinkage process, the following problems to be solved are present.

That is, according to the non-shrinkage process, since the restriction layer strongly restricts the primary surface of the unsintered ceramic laminate, the shrinkage of the unsintered ceramic laminate is suppressed, and hence the multilayer ceramic substrate can be formed with high accuracy. On the other hand, as the restriction force generated by the restriction layer is increased, the restriction layer becomes difficult to be removed after a firing step. Hence, the restriction layer may partly remain to adhere, for example, to a conductor provided on a surface of the multilayer ceramic substrate in some cases, and in this case, plating properties and/or wire bonding properties to this conductor are degraded. In order to solve this problem, although a powerful cleaning apparatus has been proposed, damage on the substrate surface is serious, and the cost is inevitably increased.

For example, when the particle diameter of an inorganic powder, such as an Al₂O₃ powder, used for the restriction layer is decreased, since the glass in the base layer and the inorganic powder particles in the restriction layer are likely to react with each other at an interface between the base layer and the restriction layer, a reaction product is easily generated at the interface, and hence a strong bond state can be formed between the base layer and the restriction layer. However, this strong bond state conversely causes a problem in that the restriction layer and also the reaction product become difficult to be removed.

On the other hand, when the particle diameter of the inorganic powder in the restriction layer is increased, since the glass in the base layer and the inorganic powder particles in the restriction layer are not likely to react with each other, the restriction layer can be easily removed; however, a force suppressing the shrinkage in a plane direction generated by the restriction layer is decreased, and in some cases, the shrinkage may not be suppressed.

As described above, although the adjustment of the particle diameter of the inorganic powder in the restriction layer is important, it is very difficult to simultaneously satisfy high restriction performance of the restriction layer and easy removal thereof, and thereby the non-shrinkage process has not been satisfactorily carried out.
Patent Document 1: Japanese Patent No. 2554415

### Disclosure of Invention

### Problems to be Solved by the Invention

Accordingly, an object of the present invention is to provide a method for manufacturing a multilayer ceramic electronic device, such as a multilayer ceramic substrate, which can solve the problems described above. Means for Solving the Problems

The present invention is directed to a method for manufacturing a multilayer ceramic substrate comprising:
(1) a first step of forming an unsintered ceramic laminate containing a low-temperature sinterable ceramic powder;
(2) a second step of disposing a restriction layer containing a sintering resistant ceramic powder which is not substantially sintered at a temperature at which the low-temperature sinterable ceramic powder is sintered on at least one primary surface of the unsintered ceramic laminate;
(3) a third step of firing the unsintered ceramic laminate on which the restriction layer is disposed at a temperature at which the low-temperature sinterable ceramic powder is sintered so as to obtain a multilayer ceramic electronic device; and
(4) a subsequent fourth step of removing the restriction layer from the multilayer ceramic electronic device.
In order to solve the technical problems described above, the method for manufacturing a multilayer ceramic substrate described above has the following configuration.

First, the unsintered ceramic laminate formed in the first step includes a first base layer which has a first conductive pattern containing Ag as a primary component and which contains a first low-temperature sinterable ceramic powder, and a second base layer which has a second conductive pattern containing Ag as a primary component and which contains a second low-temperature sinterable ceramic powder. In this case, the second base layer is formed to have a composition so that the Ag is likely to diffuse in firing as compared to that of the first base layer. In addition, the second base layer is disposed along at least one primary surface of the unsintered ceramic laminate. In the second step, the restriction layer is disposed so as to be in contact with the second base layer of the unsintered ceramic laminate.

In the unsintered ceramic laminate described above, the first and the second low-temperature sinterable ceramic powders preferably include the same constituent elements. In this case, the first and the second low-temperature sinterable ceramic powders preferably contain a first and a second glass powder, respectively, and since the second base layer is made in the first step to have a composition so that Ag is likely to diffuse as compared to that of the first base layer, a composition ratio of a glass forming the first glass powder and that of a glass forming the second glass powder are made different from each other.

The method for manufacturing a multilayer ceramic electronic device of the present invention may further comprise, after the fourth step is performed, a step of mounting a surface mount electronic device on the multilayer ceramic electronic device.

### Advantages

According to the present invention, since the second layer in contact with the restriction layer has a composition so that Ag is likely to diffuse, the glass softening point thereof decreases, and hence a strong bond state with the restriction layer can be obtained. As a result, a restriction force generated by the restriction layer can be improved, and a sufficient restriction force can be applied to the unsintered ceramic laminate in the third step, so that the multilayer ceramic electronic device can be manufactured with high accuracy.

In addition, as described above, since a high restriction force can be obtained by the restriction layer, as the sintering resistant ceramic powder contained in the restriction layer, a ceramic powder having a relatively large particle diameter can be used. Hence, in the fourth step, a state in which the restriction layer can be easily removed can be realized without causing any problems.

In addition, since the second base layer in which Ag is likely to diffuse may be disposed only at a position in contact with the restriction layer, Ag does not easily diffuse in the entire multilayer ceramic electronic device. Accordingly, degradation in electrical properties, such as degradation in insulating reliability, caused by Ag diffusion can be suppressed to a minimum level.

In the unsintered ceramic laminate described above, when the first low-temperature sinterable ceramic powder and the second low-temperature sinterable ceramic powder contain the same constituent elements, since an intermediate product is not formed between the first base layer and the second base layer in the firing, a bonding force between the first base layer and the second base layer can be increased.

In the case described above, when the first and the second low-temperature sinterable ceramic powders contain the first and the second glass powder, respectively, since the second base layer is formed in the first step to have a composition so that Ag is likely to diffuse as compared to that of the first base layer, Ag diffusivity can be easily controlled when the composition ratio of the glass forming the first glass powder and that of the glass forming the second glass powder can be easily made different from each other.

### Brief Description of Drawings

[Fig. 1] Fig. 1 is a cross-sectional view illustrating a method for manufacturing a multilayer ceramic electronic device according to a first embodiment of the present invention, and in particular is a view illustrating a method for manufacturing a multilayer ceramic substrate, the cross-sectional view showing first base-layer green sheets 1a, second base-layer green sheets 2a, and restriction-layer green sheets 10a and 11a.
[Fig. 2] Fig. 2 is a cross-sectional view showing an unsintered composite laminate 13 obtained by laminating the first base-layer green sheets 1a, the second base-layer green sheets 2a, and the restriction-layer green sheets 10a and 11a, which are shown in Fig. 1.
[Fig. 3] Fig. 3 is a cross-sectional view showing the state after the composite laminate 13 shown in Fig. 2 is fired.
[Fig. 4] Fig. 4 is a cross-sectional view showing a sintered multilayer ceramic substrate 14 obtained by removing restriction layers 10 and 11 shown in Fig. 3.
[Fig. 5] Fig. 5 is a cross-sectional view showing the state in which surface mount electronic devices 15 and 16 are mounted on the multilayer ceramic substrate 14 shown in Fig. 4.

### Reference Numerals

1a first base-layer green sheet
2a second base-layer green sheet
1 first base layer
2 second base layer
5, 6 interlayer connection conductor (conductive pattern)
7 to 9 in-plane conductor (conductive pattern)
10a, 11a restriction-layer green sheet
10, 11 restriction layer
12 unsintered ceramic laminate
13 composite laminate
14 multilayer ceramic substrate (multilayer ceramic electronic device)
15, 16 surface mounting electronic device

### Best Modes for Carrying Out the Invention

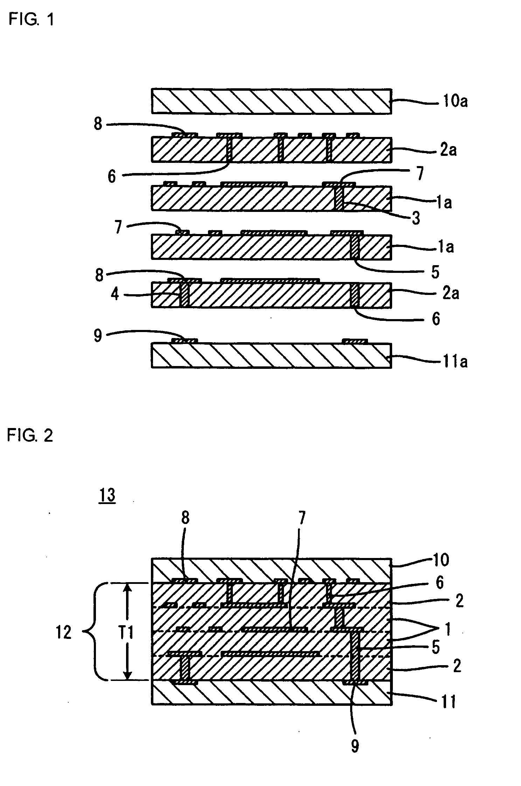

Figs. 1 to 4 are cross-sectional views illustrating a method for manufacturing a multilayer ceramic electronic device according to an embodiment of the present invention. In the figures, in particular, a method for manufacturing a multilayer ceramic substrate is shown.

First, as shown in Fig. 1, first base-layer green sheets 1a to be formed into unsintered first base layers 1 (see Fig. 2) are prepared, and second base-layer green sheets 2a to be formed into unsintered second base layers 2 (see Fig. 2) are also prepared. The first base-layer green sheets 1a and the second base-layer green sheets 2a contain a first and a second low-temperature sinterable ceramic powder, respectively. The base-layer green sheets 1a and 2a are each obtained in such a way that the low-temperature sinterable ceramic powder is dispersed in a vehicle composed of a binder, a solvent, a plasticizer, and the like to form a slurry, and the slurry thus obtained is then formed into sheets by a casting method, such as a doctor blade method.

The first and the second low-temperature sinterable ceramic powders preferably contain the same constituent elements. In more particular, after a mixture including 5 to 20 parts by weight of B₂O₃ to 100 parts by weight of a powder which contains 0 to 55 percent by weight of CaO, 45 to 70 percent by weight of SiO₂, 0 to 30 percent by weight of Al₂O₃, and 0 to 10 percent by weight of impurities is vitrified by melting at a temperature of 1,200°C or more, followed by performing quenching in water and pulverizing, so that a CaO-SiO₂-Al₂O₃-B₂O₃-based glass powder having an average particle diameter of 3.0 to 3.5 µm is formed. This glass powder is mixed with an alumina powder, and the mixtures thus obtained are used as the first and the second low-temperature sinterable ceramic powders.

In addition, in order to easily cause diffusion of Ag in the second base layer 2 as compared to that in the first base layer 1, for example, the composition ratio of a glass forming the glass powder is adjusted. That is, the composition ratio of a first glass powder contained in the first low-temperature sinterable ceramic powder is made different from that of a second glass powder contained in the second low-temperature sinterable ceramic powder. As one example, in the CaO-SiO₂-Al₂O₃-B₂O₃-based glass powder, when the amount of B₂O₃ is increased, the softening point of the glass decreases, and Ag diffusion is likely to occur; hence, the amount of B₂O₃ of the glass forming the second glass powder is set larger than that of the glass forming the first glass powder.

As the binder described above, for example, an acrylic or a butyral-based resin may be used; as the solvent, for example, toluene, xylene, or a water-based solvent may be used; and as the plasticizer, for example, DOP (dioctyl phthalate) or DBP (dibutyl phthalate) may be used.

In addition, although the unsintered first and second base layers 1 and 2 are preferably provided using the green sheets 1a and 2a, respectively, formed by the casting method described above, they may also be provided using unsintered thick-film printing layers formed by a thick film printing method.

Next, again with reference to Fig. 1, interlayer connection holes 3 and 4 are formed in the base-layer green sheets 1a and 2a, respectively, by punching machining, laser machining, or the like. In addition, a conductive paste is filled in the interlayer connection holes 3 and 4, so that unsintered interlayer connection conductors 5 and 6 are formed.

In addition, a conductive paste is printed on the base-layer green sheets 1a and 2a, so that unsintered in-plane conductors 7 and 8 are respectively formed. In the embodiment shown in the figures, in-plane conductors 9 are also formed on a restriction-layer green sheet 11a which will be described later.

As the conductive paste forming the above interlayer connection conductors 5 and 6 and the in-plane conductors 7 to 9, a paste primarily composed of Ag is used.

In addition, also as shown in Fig. 1, restriction-layer green sheets 10a and 11a to be formed into restriction layers 10 and 11 (see Fig. 2) are prepared. These restriction-layer green sheets 10a and 11a contain a sintering resistant ceramic powder, such as an alumina powder, which is not substantially sintered at a temperature at which the first and the second low-temperature sinterable ceramic powders contained in the above base-layer green sheets 1a and 2a, respectively, are sintered, and further at a temperature at which the unsintered interlayer connection conductors 5 and 6 and the unsintered in-plane conductors 7 to 9 are sintered. When the restriction-layer green sheets 10a and 11a contain an alumina powder, since the sintering temperature thereof is 1,500 to 1,600°C, sintering is not substantially performed at the sintering temperatures of the base-layer green sheets 1a and 2a, the interlayer connection conductors 5 and 6, and the in-plane conductors 7 to 9.

The restriction-layer green sheets 10a and 11a are formed in such a way that the sintering resistant ceramic powder is dispersed in a vehicle composed of a binder, a solvent, a plasticizer, and the like to form a slurry, and the slurry thus obtained is formed into sheets by a casting method, such as a doctor blade method.

Next, the first base-layer green sheets 1a and the second base-layer green sheets 2a, which are provided with the conductive patterns, such as the interlayer connection conductors 5 and 6 and the in-plane conductors 7 to 9, are laminated to each other, so that an unsintered ceramic laminate 12 as shown in Fig. 2 is formed. In the unsintered ceramic laminate 12, the first base-layer green sheets 1a form the unsintered first base layers 1, and the second base-layer green sheets 2a form the unsintered second layers 2. In this embodiment, in the unsintered ceramic laminate 12, the second base layers 2 are laminated so as to sandwich the first base layers 1 in a lamination direction.

In addition, the restriction-layer green sheets 10a and 11a are laminated so as to sandwich the unsintered ceramic laminate 12 in a lamination direction, so that the restriction layers 10 and 11 are provided. In this lamination state, the restriction layers 10 and 11 are in contact with the second base layers 2. In addition, instead of providing the restriction layers 10 and 11 using the green sheets 10a and 11a, they may be provided using thick-film printing layers formed by a thick film printing method.

The unsintered ceramic laminate 12 thus obtained which is provided with the restriction layers 10 and 11 is pressed by an isostatic press or a uniaxial press using a mold, so that a composite laminate 13 is obtained.

When the unsintered ceramic laminate 12 shown in Fig. 2 is in a collective substrate state to obtain a plurality of multilayer ceramic substrates, in order to easily perform a subsequent division step, a step of forming grooves in at least one primary surface of the unsintered ceramic laminate 12 to a depth of approximately 20% of the thickness thereof is performed after the composite laminate 13 is formed, that is before or after the above-described pressing step is performed.

Next, the composite laminate 13 is fired at a temperature, for example, of 1,050°C or less and more preferably 800 to 1,000°C at which the first and the second low-temperature sinterable ceramic powders contained in the first and the second base layers 1 and 2, respectively, are sintered.

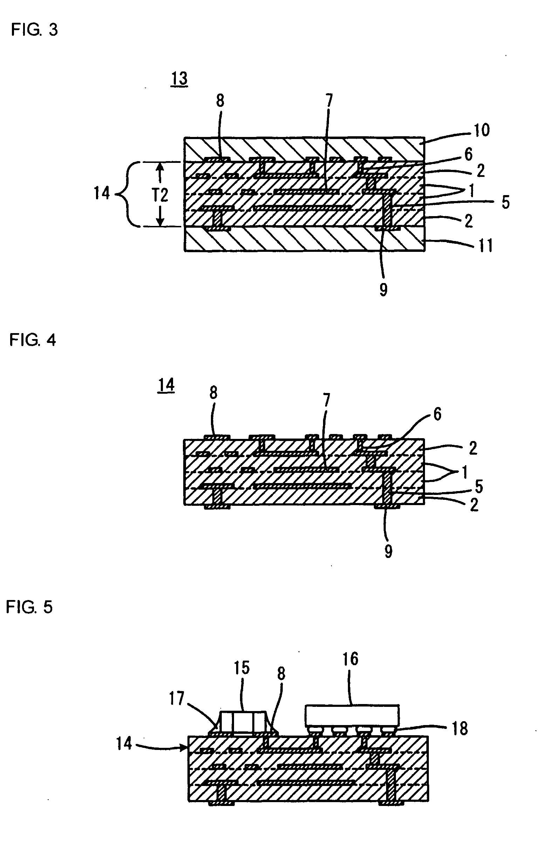

As a result of the above firing step, in the composite laminate 13, the restriction layers 10 and 11 are not substantially sintered, but the unsintered ceramic laminate 12 is sintered, so that as shown in Fig. 3, a sintered ceramic laminate, that is, a multilayer ceramic substrate 14, is obtained between the restriction layers 10 and 11.

As apparent when Figs. 2 and 3 are compared with each other, because of the function of the restriction layers 10 and 11, the sintered multilayer ceramic substrate 14 is suppressed from being shrunk as compared to the unsintered ceramic laminate 12. In this embodiment, since the second base layers 2 in contact with the restriction layers 10 and 11 each have a composition so that Ag is likely to diffuse as compared to that of each of the first base layers 1, the glass softening point decreases, and hence a strong bond state with the restriction layers 10 and 11 can be obtained. As a result, the restriction force generated by the restriction layers 10 and 11 can be improved, and in the above firing step, a sufficient restriction force can be applied to the unsintered ceramic laminate 12, so that the multilayer ceramic substrate 14 can be manufactured with high accuracy.

In addition, as described above, in the unsintered ceramic laminate 12, the first low-temperature sinterable ceramic powder contained in the first base layer 1 and the second low-temperature sinterable ceramic powder contained in the second base layer 2 contain the same constituent elements. Accordingly, in the firing described above, since an intermediate product is not formed between the first base layer 1 and the second base layer 2, the bonding force between the first base layer 1 and the second base layer 2 can be increased, so that generation of peeling therebetween can be prevented.

In addition, a thickness T1 of the unsintered ceramic laminate 12 of Fig. 2 and a thickness T2 of the sintered multilayer ceramic substrate 14 of Fig. 3 are shown in a thickness direction, and T2<T1 holds; hence, the sintered multilayer ceramic substrate 14 is relatively largely shrunk in the thickness direction as compared to the unsintered ceramic laminate 12 before firing.

Next, the restriction layers 10 and 11 are removed from the fired composited laminate 13 by a method, such as wet blast, sand blast, or brushing, so that the multilayer ceramic substrate 14 as shown in Fig. 4 is obtained. As described above, since a high bonding force can be obtained by the restriction layers 10 and 11, the particle diameter of the sintering resistant ceramic powder contained in the restriction layers 10 and 11 can be set relatively large. As a result, the restriction layers 10 and 11 can be easily removed, so that residues of the restriction layers 10 and 11 hardly remain on the surfaces of the multilayer ceramic substrate 14.

Next, whenever necessary, the surfaces of the multilayer ceramic substrate 14 are cleaned. In this step, an excessively strong cleaning force is not necessarily applied. As a cleaning method, a physical treatment, such as ultrasonic cleaning or blasting of alumina abrasive particles or the like, and a chemical treatment, such as etching, may be used alone or in combination.

Subsequently, plating is performed on some of the in-plane conductors 7 to 9 which are exposed at the surfaces of the multilayer ceramic substrate 14. This plating is performed to enhance mounting reliability of surface mount electronic devices which will be describe later, and for example, plating of Ni/Au, Ni/Pd/Au, Ni/Sn, or the like is performed. As a plating method, either electroplating or electroless plating may be used.

In the multilayer ceramic substrate 14 thus obtained, since the second base layers 2 in which Ag easily diffuses may be disposed only at places in contact with the restriction layers 10 and 11, Ag does not easily diffuse in the entire multilayer ceramic substrate 14. Hence, degradation in electrical properties, such as degradation in insulating reliability, caused by the Ag diffusion can be suppressed to a minimum level.

As shown in a cross-sectional view of Fig. 5, surface mount electronic devices 15 and 16 are mounted on an upper primary surface of the multilayer ceramic substrate 14. The surface mount electronic device 15 is, for example, a chip capacitor and is electrically connected to in-plane conductors 8 located on an external surface through solders 17. The other surface mount electronic device 16 is, for example, a semiconductor chip, and is electrically connected to in-plane conductors 8 located on the external surface through solder bumps 18. Although not shown in Fig. 5, whenever necessary, the surface mount electronic devices 15 and 16 may be resin-sealed.

As described above, when the multilayer ceramic substrate 14 is formed in a collective substrate state, a division step is preferably performed after the surface mount electronic devices 15 and 16 are mounted.

Heretofore, although the present invention has been described with reference to the embodiment shown in the figures, other various embodiments may be performed within the scope of the present invention.

For example, in the embodiment shown in the figures, the second base layers 2 are disposed along the two primary surfaces of the unsintered ceramic laminate 12 or the multilayer ceramic substrate 14, and the restriction layers 10 and 11 are disposed along the two primary surfaces of the composite laminate 13; however, when the restriction layer is disposed only along one primary surface of the composite laminate, the second base layer may be disposed only along the primary surface at the side at which this restriction layer is disposed.

In addition, the number of the first base layers 1 and that of the second base layers 2, in particular, the number of the first base layers 1, may be arbitrarily changed in accordance with required design.

In addition, the present invention may also be applied to a multilayer ceramic electronic device having a different function as well as the multilayer ceramic substrate.

Next, Examples performed in order to confirm the advantages of the present invention will be described.

As first base-layer green sheets and second base-layer green sheets, sheets containing an alumina powder and a borosilicate glass powder at a ratio of 60: 40 were prepared. The composition ratio of the borosilicate glass contained in the first base-layer green sheets and that of the borosilicate glass contained in the second base-layer green sheets were set as shown in Table 1.

**[Table 1]**

| | First base layer (percent by weight) | Second base layer (percent by weight) |
|---|---|---|
| SiO₂ | 44 | 59 |
| B₂O₃ | 6 | 10 |
| CaO | 43 | 25 |
| Al₂O₃ | 7 | 6 |

As shown in Table 1, the amount of B₂O₃ of the borosilicate glass contained in the second base-layer green sheet was set larger than that of the borosilicate glass contained in the first base-layer green sheet, and hence the softening point of the glass of the former was set lower than that of the glass of the latter.

In addition, as restriction-layer green sheets, sheets containing an alumina powder which had an average particle diameter of 1.0 µm and a thickness of 300 µm were prepared.

Subsequently, an appropriate number of the first base-layer green sheets and an appropriate number of the second base-layer green sheets were respectively laminated so that the total thickness of a first base layer portion was 300 µm and the total thickness of one of second base layer portions, which sandwiched the first base layer portion in a lamination direction, was 15 µm, thereby forming an unsintered ceramic laminate. Furthermore, the restriction-layer green sheets described above were laminated so as to sandwich this unsintered ceramic laminate in the lamination direction and were then pressure-bonded, thereby forming an unsintered composite laminate.

When the above unsintered ceramic laminate was formed, two microstrip lines were formed therein as a conductive pattern primarily composed of Ag, so that a bandpass filter combined with a 5-GHz resonator was formed.

Next, after the above composite laminate was fired at a temperature of 900°C, the restriction layers were removed by wet blast, so that a multilayer ceramic electronic device of Example within the scope of the present invention was obtained.

On the other hand, as a multilayer ceramic electronic device out of the scope of the present invention which was used for comparison purpose, an electronic device in which the above first base-layer green sheets were only laminated (Comparative Example 1) and an electronic device in which the above second base-layer green sheets were only laminated (Comparative Example 2) were formed.

First, when the bonding force generated by the restriction layer of each of Example and Comparative Examples 1 and 2 thus obtained was evaluated, according to Example and Comparative Example 2, so-called non-shrinkage firing (rate of shrinkage = dimension after firing/dimension before firing = 99.9%) was realized; however, according to Comparative Example 1, the restriction by the restriction layer did not sufficiently work, and a large shrinkage was generated.

In addition, when filter characteristic values of Example and Comparative Example 2 were evaluated, the insertion loss was 0.5 dB according to Example; however, the insertion loss was increased to 1.0 dB according to Comparative Example 2.

In addition, when a Ag diffusion amount according to Example was evaluated by a mapping analysis using WDX, it was confirmed that the Ag diffusion amount of the second base layer portion was large as compared to that of the first base layer portion.

As for removability of the restriction layer, a significant difference between Example and Comparative Examples 1 and 2 was not observed since the restriction layers containing an alumina powder which had the same average particle diameter were used.

## Claims

1. A method for manufacturing a multilayer ceramic electronic device, comprising:
a first step of forming an unsintered ceramic laminate including a first base layer which has a first conductive pattern containing Ag as a primary component and which contains a first low-temperature sinterable ceramic powder, and a second base layer which has a second conductive pattern containing Ag as a primary component, which contains a second low-temperature sinterable ceramic powder, and which has a composition so that Ag is likely to diffuse in firing as compared to that of the first base layer, the second base layer being disposed along at least one primary surface of the unsintered ceramic laminate;
a second step of disposing a restriction layer containing a sintering resistant ceramic powder which is not substantially sintered at a temperature at which the first and the second low-temperature sinterable ceramic powders are sintered so as to be in contact with the second base layer of the unsintered ceramic laminate;
a third step of firing the unsintered ceramic laminate on which the restriction layer is disposed at a temperature at which the first and the second low-temperature sinterable ceramic powders are sintered so as to obtain a multilayer ceramic electronic device; and
a subsequent fourth step of removing the restriction layer from the multilayer ceramic electronic device.

2. The method for manufacturing a multilayer ceramic electronic device according to Claim 1, wherein in the unsintered ceramic laminate, the first and the second low-temperature sinterable ceramic powders include the same constituent elements.

3. The method for manufacturing a multilayer ceramic electronic device according to Claim 2, wherein in the unsintered ceramic laminate, the first and the second low-temperature sinterable ceramic powders contains a first and a second glass powder, respectively, and in order to enable the second base layer to have a composition in the first step so that Ag is likely to diffuse as compared to that of the first base layer, a glass composition ratio of a glass forming the first glass powder is made different from that of a glass forming the second glass powder.

4. The method for manufacturing a multilayer ceramic electronic device according to one of Claims 1 to 3, further comprising, after the fourth step is performed, a step of mounting a surface mount electronic device on the multilayer ceramic electronic device.
